# EUROPEAN PATENT SPECIFICATION

(11) **EP 4 175 311 B1**
(45) Date of publication and mention of the grant of the patent: **13.08.2025**
(21) Application number: 22198717.5
(22) Date of filing: 29.09.2022
(51) Int. Cl.: H04N 25/773

(54) **PHOTON COUNTING IMAGE SENSOR, IMAGE ACQUISITION APPARATUS AND ELECTRONIC APPARATUS INCLUDING THE IMAGE ACQUISITION APPARATUS**
PHOTONENZÄHLENDER BILDSENSOR, BILDERFASSUNGSVORRICHTUNG UND ELEKTRONISCHE VORRICHTUNG MIT DER BILDERFASSUNGSVORRICHTUNG
CAPTEUR D'IMAGE À COMPTAGE DE PHOTONS, APPAREIL D'ACQUISITION D'IMAGE ET APPAREIL ÉLECTRONIQUE COMPRENANT L'APPAREIL D'ACQUISITION D'IMAGE

(30) Priority: 28.10.2021 KR 20210145863
(43) Date of publication of application: 03.05.2023
(73) Proprietor: Samsung Electronics Co., Ltd., Gyeonggi-do 16677 (KR)
(72) Inventor: Kim, Jungwoo, 16678 Suwon-si, Gyeonggi-do (KR); Min, Byeongil, 16678 Suwon-si, Gyeonggi-do (KR)
(74) Representative: Grünecker Patent- und Rechtsanwälte PartG mbB

(56) References cited:
- US-A1- 2019 113 385
- US-A1- 2019 250 257
- US-A1- 2019 327 424
- US-B2- 9 210 350

## Description

### BACKGROUND

### 1. Field

The disclosure relates to image acquisition apparatuses, and electronic apparatuses including the image acquisition apparatuses.

### 2. Description of the Related Art

Image sensors receive light incident thereon from an object and photoelectrically convert the received light into an electrical signal.

The image sensors use a color filter including an array of filter elements capable of selectively transmitting red light, green light, and blue light for color expression, sense the amount of light that passed through each filter element, and then form a color image of an object through image processing.

Characteristics of the image sensors such as resolution, frame rate, low light imaging, and high dynamic range (hereinafter, referred to as HDR) have been gradually improved. In order to simultaneously improve the HDR and frame rate, a new imaging method has been proposed, and recently, an image sensor to which photon counting imaging technology is applied has been developed.

Photon counting imaging uses a fast photodiode, for example, a single photon avalanche diode (hereinafter, referred to as SPAD), to count the number of photons incident on a pixel for a certain period of time on a time axis, measures the amount of light for each pixel, and generates a two-dimensional image.
Patent document US 2019/327424 A1 discloses an image sensor with a plurality of pixels, wherein each pixel comprises a single photon avalanche diode, a pulse generator and a counter. This document further discloses that sensor linearity can be improved by controlling the period of the signal pulse to be longer when the image sensor is in a low illuminance state. Vice versa, the pulse period is decreased when the image sensor is in a high illuminance state. A similar image sensor is also disclosed in patent document US 2019/113385.
Patent document US 2019/250257 A1 discloses a light detection and ranging (LIDAR) apparatus with a detector array comprising single photon detectors, wherein a pulse width of a pulse signal is controlled based on detected levels of background and/or signal photons.

### SUMMARY

Provided are image sensors, image acquisition apparatuses, and electronic apparatuses including the image acquisition apparatuses.

The invention is claimed in the independent claims. Preferred embodiments are specified in the dependent claims.

Additional aspects will be set forth in part in the description which follows and, in part, will be apparent from the description, or may be learned by practice of the presented example embodiments of the disclosure.

### BRIEF DESCRIPTION OF THE DRAWINGS

The above and other aspects, features, and advantages of certain example embodiments of the disclosure will be more apparent from the following description taken in conjunction with the accompanying drawings, in which:
FIG. 1 is a schematic block diagram of an image acquisition apparatus according to an example embodiment;
FIG. 2 is a detailed block diagram of an image sensor shown in FIG. 1;
FIG. 3 is a circuit diagram of the image sensor shown in FIG. 2;
FIG. 4 is a diagram illustrating a pixel structure of an image sensor according to the related art;
FIG. 5 is a diagram illustrating a modulation of a period of a pulse signal of an image sensor, according to another example embodiment;
FIG. 6 is a diagram illustrating a modulation of a period of a pulse signal of an image sensor, according to another example embodiment;
FIG. 7 is a schematic block diagram of an image acquisition apparatus according to another example embodiment;
FIG. 8 is a flowchart of a method of modulating a period of a pulse signal of an image signal, according to another example embodiment;
FIG. 9 is a flowchart of a method of modulating a period of a pulse signal of an image signal, according to another example embodiment;
FIG. 10 is a block diagram of a schematic structure of an electronic apparatus according to another example embodiment;
FIG. 11 is a block diagram schematically illustrating a camera module included in the electronic apparatus of FIG. 10; and
FIGS. 12 to 21 are views illustrating various examples of an electronic apparatus including an image acquisition apparatus according to an example embodiment.

### DETAILED DESCRIPTION

Reference will now be made in detail to example embodiments, examples of which are illustrated in the accompanying drawings, wherein like reference numerals refer to like elements throughout. In this regard, the example embodiments may have different forms and should not be construed as being limited to the descriptions set forth herein. Accordingly, the example embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, example embodiments will be described in detail with reference to the accompanying drawings. The example embodiments described below are only examples, and thus, it should be understood that the example embodiments may be modified in various forms. **In** the drawings, like reference numerals refer to like elements throughout, and the sizes of elements may be exaggerated for clarity.

**In** the following description, when an element is referred to as being "above" or "on" another element, it may be directly on the other element while making contact with the other element or may be above the other element without making contact with the other element.

Although terms such as "first" and "second" are used to describe various elements, these terms are only used to distinguish one element from another element. These terms do not limit elements to having different materials or structures.

As used herein, the singular forms "a," "an," and "the" are intended to include the plural forms as well, unless the context clearly indicates otherwise. In addition, it will be understood that when a unit is referred to as "comprising" another element, it does not preclude the possibility that one or more other elements may exist or may be added.

**In** the disclosure, terms such as "unit" or "module" may be used to denote a unit that has at least one function or operation and is implemented with hardware, software, or a combination of hardware and software.

An element referred to with the definite article or a demonstrative pronoun may be construed as the element or the elements even though it has a singular form.

Operations of a method may be performed in an appropriate order unless explicitly described in terms of order or described to the contrary. **In** addition, examples or exemplary terms (for example, "such as" and "etc.") are used for the purpose of description and are not intended to limit the scope of the disclosure unless defined by the claims.

In an example embodiment, a single photon avalanche diode (SPAD) refers to a next-generation semiconductor light device with extremely high efficiency to the extent that a single photon is detected, due to very high gain characteristics of the device. In the SPAD, when a voltage greater than a breakdown voltage of the device is applied, carriers may be accelerated according to a very large electric field, causing a strong collision with an atom, and thus, an impact ionization phenomenon may occur in which electrons bound to the atom are released and the number of free electrons rapidly increases. This is referred to as an avalanche multiplication, and due to this effect, the number of free electrons created due to photons irradiated to an image sensor from the outside significantly increases. In other words, even when a surrounding environment is very dark or light is irradiated from very far away, and a very small level of photons enters, it may be recognized as if a very large number of photons entered, by amplifying the photons.

In photon counting imaging, a two-dimensional image may be implemented by counting the number of photons incident on a pixel during a certain period of time by using an SPAD, and measuring an amount of light per pixel.

In a related-art image sensor, a two-dimensional image is generated by accumulating, in floating diffusion, photons incident on the image sensor during a certain period of time, and transmitting the voltage change to an external readout circuit. On the other hand, in an image sensor using photon counting, a conversion into digital information may be performed in a pixel unit.

A pixel for photon counting imaging may include a high-speed photodiode, a pulse generator, and a counter circuit. Each pixel individually operates independently, and when a photon is incident on the pixel, a flow of current occurs in the high-speed photodiode, and a digital pulse is output from the pulse generator. The number of pulses of the digital pulse are continuously accumulated in a counter at a rear end. Accordingly, when the output pulses are counted within a given time, a digital value proportional to an amount of photons may be obtained, and thus, a two-dimensional image may be generated. The photon counting imaging has an advantage in that a high-speed shooting and a high dynamic range (HDR) compared to existing image sensors may be implemented, and that a dynamic range greater than or equal to 120 dB may be implemented. However, the number of pulses changes significantly according to an illuminance, and thus, it is difficult to select a size of the counter. In other words, the number of pulses decreases in a small illuminance, and the number of pulses increases in a high illuminance, and thus, a counter having a large memory is necessary for normal operation.

In an example embodiment, even when the counter in a pixel has a fixed capacity or fixed size, a pulse period is increased when there is a high ambient illuminance so that a value greater than the size of the counter may be counted even in a high illuminance. In addition, a pulse period of each sub-frame may be sequentially modulated so that a size of the pixel may be reduced and a frame rate may be improved.

In an example embodiment, the term "pixel" is used to refer to only a photodiode that receives light, or components or direct circuits implemented in the pixel. For example, the "pixel" may be used to collectively refer to a photodiode, a pulse generator, and a counter that implement one pixel.

In an example embodiment, the term "image sensor" is used to refer to a photoelectric conversion device that detects light and converts the detected light into an electric signal. Thus, the "image sensor" is used to refer to a pixel, a pixel array, or a pixel and a pixel circuit together.

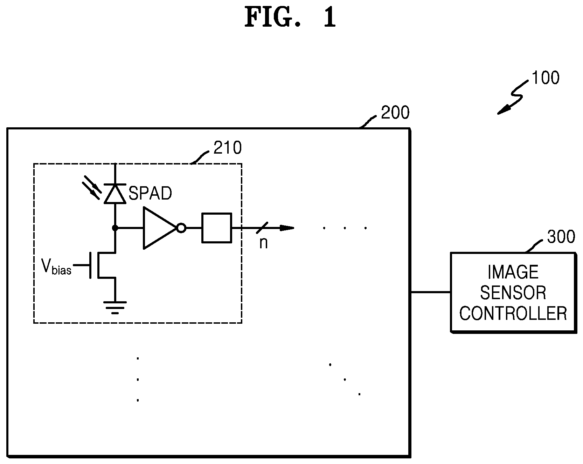

FIG. 1 is a schematic block diagram of an image acquisition apparatus 100 according to an example embodiment.

Referring to FIG. 1, the image acquisition apparatus 100 may include a pixel array 200 and an image sensor controller 300.

According to an example embodiment, a plurality of pixels 210 are arranged in the pixel array 200. The pixel array may be an MxN matrix, where M and N are greater than or equal 1. Each of the pixels 210 may be independently operated. According to an example embodiment, the image acquisition apparatus 100 may include peripheral circuits, a vertical scan circuit, a horizontal scan circuit, a reading circuit, an output circuit, and a control circuit. However, the disclosure is not limited thereto, and as such, other circuits and functionalities may be provided. The plurality of pixels 210 and the peripheral circuits may be arranged on different layers from each other. For example, a layer on which the plurality of pixels 210 are arranged may be stacked on a chip layer of a readout circuit. In an example embodiment, the pixel 210 includes an SPAD and counts a single photon, and thus may have low noise and an HDR.

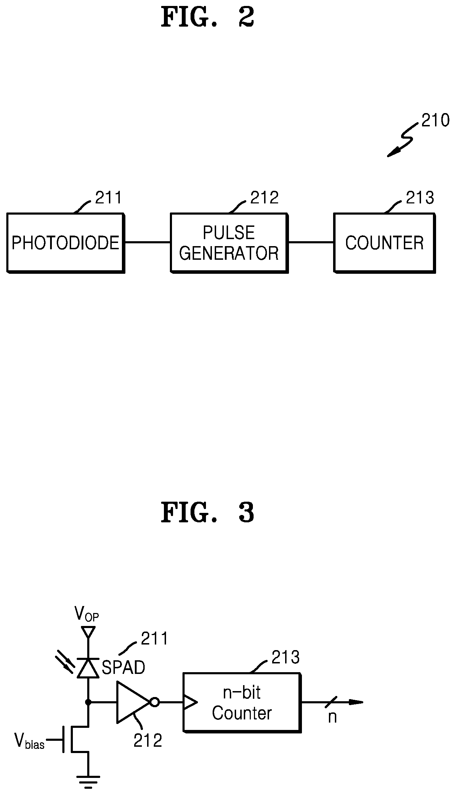

Each of the pixels 210 includes a photodiode, a pulse generator, and a counter. In an example embodiment, the pulse generator may generate a pulse signal based on an electric signal generated according to photons incident on the photodiode. In an example embodiment, in the pulse generator, a period of the pulse signal may be modulated according to an ambient illuminance. According to the invention, when the ambient illuminance is high, the period of the pulse signal is increased. The counter may count and output the number of pulse signals output from the pulse generator. A structure and detailed operation of the pixel 210 are described below, with reference to FIGS. 2 and 3.

The image sensor controller 300 may generate an image signal by using an output value output from the pixel array 200. Here, the output value may include a counting value of a counter of each pixel and a period of a pulse signal. The image sensor controller 300 may control the pulse generator of the pixel 210 according to an ambient illuminance to modulate the period of the pulse signal. When an ambient illuminance value is a threshold value or greater, a predetermined period of the pulse signal is increased by a certain time. Here, the certain time may be a value that may be arbitrarily determined, and may be a value determined differently according to an ambient illuminance. For instance, according to an example embodiment, the ambient illuminance value may be a magnitude of an amount of incident light. In addition, when a counting value output from the pixel array 200 is a threshold value or greater, the image sensor controller 300 may increase the period of the pulse signal of the pulse generator.

In order to generate an image signal, the image sensor controller 300 may divide one frame period into a plurality of sub-frame periods. In addition, an output value of the counter for each sub-frame time may be compared with the capacity of the counter, so that the period of the pulse signal may be modulated according to a result of the comparison. In addition, the image sensor controller 300 may compare the output value of the counter with the capacity of the counter and sequentially increase the period of the pulse signal for the sub-frame. The capacity of the counter is a value that may be determined according to the number of bits of the counter. Here, pulse periods of the same sub-frame are equal to each other, but may be different between pulse periods for different sub-frames.

FIG. 2 is a detailed block diagram of pixel 210 shown in FIG. 1.

Referring to FIG. 2, the pixel 210 includes a photodiode 211, a pulse generator 212, and a counter 213. The pixel 210 senses an amount of light by counting the number of photons incident during a predetermined time, that is, an exposure period, by using a trigger pulse induced by photons incident on the photodiode 211.

The photodiode includes an avalanche photodiode (hereinafter, referred to as an APD) or SPAD operating in a Geiger mode. In the Geiger mode, a reverse voltage greater than a breakdown voltage is applied to the APD so as to detect a single photon. In the Geiger mode, because an intensity of an electric field applied to an amplification layer is large, even when a small amount of photons is absorbed, a breakdown phenomenon of an avalanche current occurs so that a large current pulse is output, and thus, a single photon may be detected.

The pulse generator 212 generates a pulse signal based on an electric signal generated according to a photon incident on the photodiode 211. The pulse generator 212 may generate a pulse at a frequency according to a frequency at which a photon is received. Here, a period of the pulse signal may be modulated according to an ambient illuminance. For example, when the ambient illuminance is high, the period of the pulse signal may be increased for a certain period of time.

The counter 213 counts and outputs the number of pulse signals. A counting value or counting result value output by the counter 213 may become a pixel value. Here, the counting value is a sum of the number of photons input within a frame period. The counter 213 may temporarily store the counting value, and output the counting value according to an external control signal.

According to an example embodiment, the image acquisition apparatus 100 may include an image signal generator may generate an image signal by using the output value of the counter 213, that is, a pixel value. According to another example embodiment, the image signal generator may be provided external to the image acquisition apparatus 100.

FIG. 3 is a circuit diagram of the pixel 210 shown in FIG. 2.

Referring to FIGS. 2 and 3, the pixel 210 includes a photodiode. In addition, the photodiode 211 includes an SPAD. A cathode electrode of the photodiode 211 may be connected to an operating voltage Vop, and an anode electrode may be connected to an n-type metal-oxide-semiconductor field-effect transistor (NMOS) and an input side of the pulse generator 212. A gate electrode of the NMOS transistor may be connected to a bias voltage Vbias.

The pulse generator 212 may include an inverter circuit. An output of the pulse generator 212 may be connected to the counter 213. However, the disclosure is not limited thereto, and as such, the pulse generator 212 may include other components and/or circuit elements.

The counter 213 may have n bits, for example, 8 to 12 bits. The size of the counter 213 is not limited thereto, and a counter of various sizes may be used according to a pixel size or applications of the image sensor. In addition, in an example embodiment, the number of incident photons may be counted by increasing the period of the pulse signal according to an ambient illuminance, that is, in a high illuminance or even when the number of photons is large, and thus, a counter overflow may be prevented without the increase in size of the counter. The counter 213 may include a synchronous counter, a non-synchronous counter, or a non-synchronous ripple counter. The counter 213 may include a D flip-flop circuit.

Referring to FIG. 3, when a reverse bias voltage greater than a breakdown voltage is applied to the cathode electrode of the SPAD 211 as the operating voltage Vop, carriers generated by the incidence of a single photon causes avalanche amplification, so that a large current is applied to the input side of the pulse generator 212 through the SPAD 211.

The pulse generator 212 may generate an electric signal applied to the input side thereof, as a pulse signal. Here, the pulse generator 212 may include an inverter circuit. In an example embodiment, in the pulse generator 212, the period of the pulse signal is modulated or varies according to an ambient illuminance. For example, an electric signal output from the SPAD 211 and a control signal value corresponding to an ambient illuminance value may be input to a certain logic circuit so that the period of the pulse signal is modulated. For example, when the ambient illuminance is high, when a control signal having a certain length is input, the pulse generator 212 increases the period of the pulse signal by the corresponding length. In addition, the pulse generator 212 may receive a control signal of an external control circuit or an output signal of an external illuminance sensor, to modulate the period of the pulse signal.

The NMOS transistor may be turned on or off by applying a bias voltage to the gate electrode of the NMOS transistor, and a current generated by the SPAD 211 may be transmitted to the pulse generator 212. Here, the NMOS transistor is shown, but the disclosure is not limited thereto, and various bias voltage application circuits may be applicable.

According to an example embodiment, the image acquisition apparatus 100 may include a quenching circuit for restricting an excess current due to avalanche amplification occurring in the SPAD 211. The greater the reverse voltage applied to the SPAD, the greater the probability that thermal electrons are in an excited state and tunneling probability is present, and thus, a dark current in which an avalanche current occurs without an absorption of photons may increase. When the avalanche current occurs, an excess current may flow. Thus, a continuous flow of the avalanche current may be suppressed by the quenching circuit.

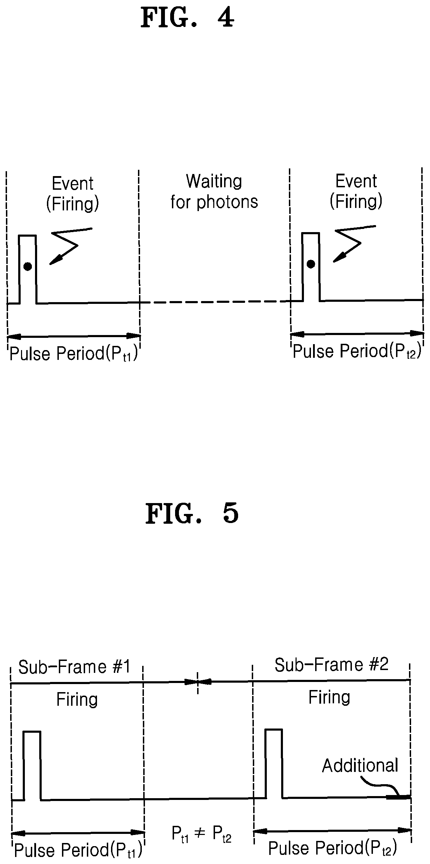

Referring to FIG. 4, a timing and period of a pulse signal of the pulse generator 212 are shown. Pₜ₁ is a pulse period of a first frame or a first sub-frame, and Pₜ₂ is a pulse period of a second frame or a second sub-frame. As shown in FIG. 4, when light is incident on the photodiode 211, the pulse generator 212 may generate a pulse signal generated by a single photon during a period Pt of the pulse signal. In addition, after a standby time elapses, during a next period, the pulse generator 212 may generate a pulse signal generated by a single photon. Here, in a low light condition, the number of incident photons is small, and an interval at which a photon is incident increases, and thus, the standby time shown in FIG. 4 increases so that a capacity of the counter 213 is not exceeded. However, in a high light condition, a standby time decreases or becomes zero, and thus, the capacity of the counter 213 is exceeded.

Referring to FIG. 5, a timing and period of a pulse signal of the pulse generator 212 are shown. Pₜ₁ is a pulse period of a first frame or a first sub-frame, and Pₜ₂ is a pulse period of a second frame or a second sub-frame. As shown, the period Pₜ₂ of the second pulse signal becomes greater than the period Pₜ₁ of the first pulse signal. In other words, when the period of the pulse signal increases, the number of counts performed during a single frame or a single sub-frame decreases, and thus, the capacity of the counter 213 may not be exceeded.

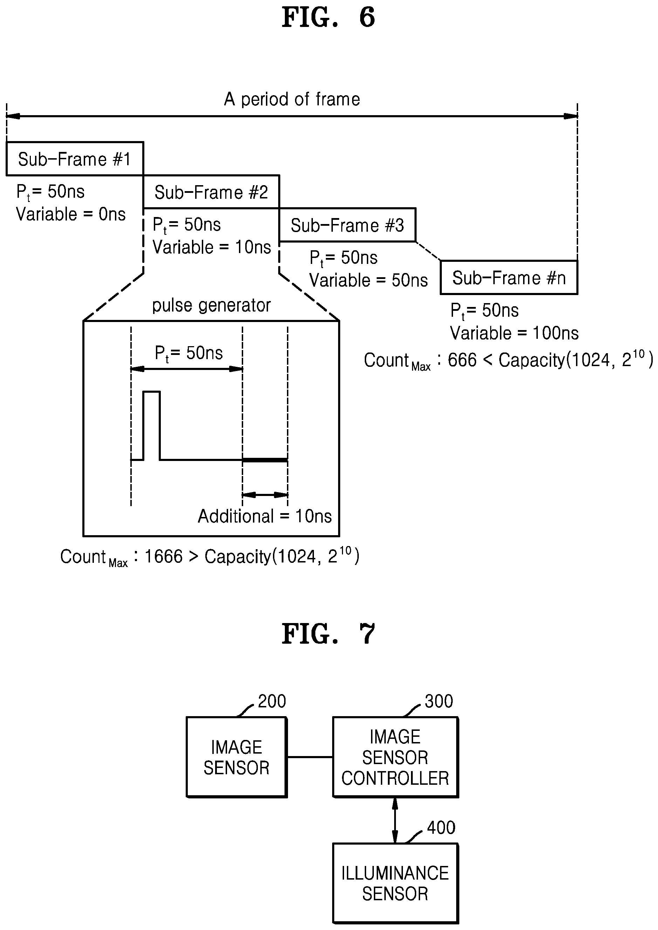

FIG. 6 is a diagram illustrating a modulation of a period of a pulse signal of an image sensor, according to another example embodiment.

Referring to FIG. 6, one frame may be divided into a plurality of sub-frames (first to n^{th} sub-frames). Here, a period of the sub-frame is 100 µs, the counter is in 10 bits, and a capacity of the counter is 2¹⁰, that is, 1024. A basic pulse period Pt of each of the sub-frames is 50 ns. Additional pulse periods (variables) of the first to n^{th} sub-frames may be different from each other. As shown, a period Pₜ₁ of a pulse signal of the first sub-frame may be 50 ns, a period Pₜ₂ of a pulse signal of the second sub-frame may be 60 ns, a period Pₜ₃ of a pulse signal of the third sub-frame may be 100 ns, and a period Pₜₙ of a pulse signal \of the n^{th} sub-frame may be 150 ns. Here, the basic period Pt of the pulse signal is the same at 50 ns, and an additional period (variable) from the second sub-frame to the n^{th} sub-frame gradually increases by 10 ns, 50 ns, and 100 ns. Each of the additional periods may vary according to an ambient illuminance value or an amount of light. In an example embodiment, when the ambient illuminance is high, a period of a pulse signal of each sub-frame, that is, the additional period, may be increased. Here, the period of a sub-frame, the counter capacity, the basic period of the pulse signal, and the additional frequency are examples, and may be variously set according to a specification or application of the image sensor.

The maximum expected output value of the counter for each sub-frame and the counter capacity may be compared with each other, and when the maximum expected output value of the counter is greater than the counter capacity, the period of the pulse signal for the sub-frame may be increased.

The maximum expected output value of the counter for the second sub-frame may be 1666, and a 10-bit counter has a capacity of 1024. Thus, because the maximum expected output value of the counter is greater than the counter capacity, the period of the pulse signal for the third sub-frame may be increased by 50 ns. In addition, when the maximum expected output value of the counter for the n^{th} sub frame is 666, which is less than the counter capacity of 1024, an image signal may be generated by using output values of the counter and periods of the pulse signal up to the n^{th} frame.

In an example embodiment, in imaging using photon counting, a sequence may be started by dividing a single frame into a plurality of sub-frames. An image signal may be generated by using an output value of the counter (a counting value) and period information. A period may be sequentially increased based on two pieces of information generated for each sub-frame, that is, a counting value and a period, so that a sequence may be performed up to a sub-frame in which the counter value does not exceed the counter capacity, thereby obtaining one piece of frame information. An image may be generated by using a counting value and period modulation information of the sub-frame.

In an example embodiment, it is described that a measurement or determination of an ambient illuminance includes dividing a frame into sub-frames, and determining whether a counting value of each of the sub-frames exceeds a counter capacity. However, the disclosure is not limited thereto, and it may be determined whether to increase a period of a pulse signal considering counting values of a few sub-frames that are sequentially input.

FIG. 7 is a schematic block diagram of an image acquisition apparatus according to another example embodiment.

Referring to FIG. 7, the image acquisition apparatus may include an image sensor 200, the image sensor controller 300, and an illuminance sensor 400. In an example embodiment, when an ambient illuminance is high, that is, when an ambient illuminance value is a threshold value or greater, the image sensor controller 300 may increase a period of a pulse signal for frames of the image sensor 200. The illuminance sensor 400 may measure an ambient illuminance, and provide the measured illuminance value to the image sensor controller 300. When the illuminance value received from the illuminance sensor 400 is a threshold value or greater, the image sensor controller 300 may increase a period of a pulse signal of a pulse generator of the image sensor 200. Here, the sensing value of the illuminance sensor 400 is provided to the image sensor controller 300. However, the disclosure is not limited thereto, and it may be implemented such that the sensing value of the illuminance sensor 400 may be provided to the input side of the pulse generator.

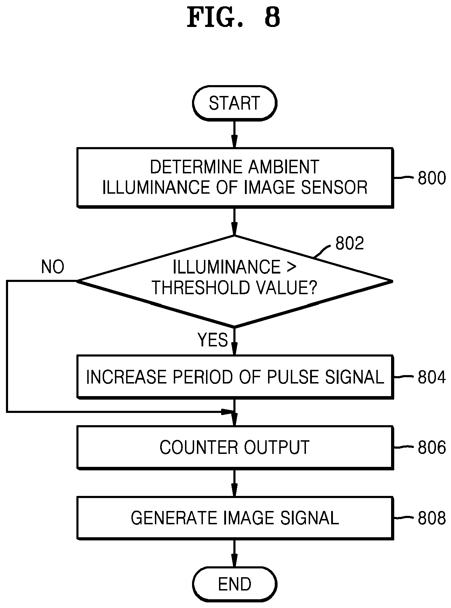

FIG. 8 is a flowchart of a method of modulating a period of a pulse signal of an image signal, according to another example embodiment.

Referring to FIG. 8, in operation 800, an ambient illuminance of an image sensor may be determined.

**In** operation 802, it may be determined whether the illuminance value is greater than a threshold value. **In** operation 804, when the illuminance is greater than the threshold value, a period of a pulse signal may be increased. **In** operation 806, a counting value of a counter may be output, and in operation 808, an image signal may be generated.

When the illuminance value is not greater than the threshold value in operation 802, the counting value of the counter may be output in operation 806, and the image signal may be generated in operation 808.

**In** an example embodiment, in a high illuminance, the pulse period may be increased so as not to exceed the capacity of the counter, so that the number of counts performed during a single frame time is reduced, thereby performing photon counting with a designed counter capacity.

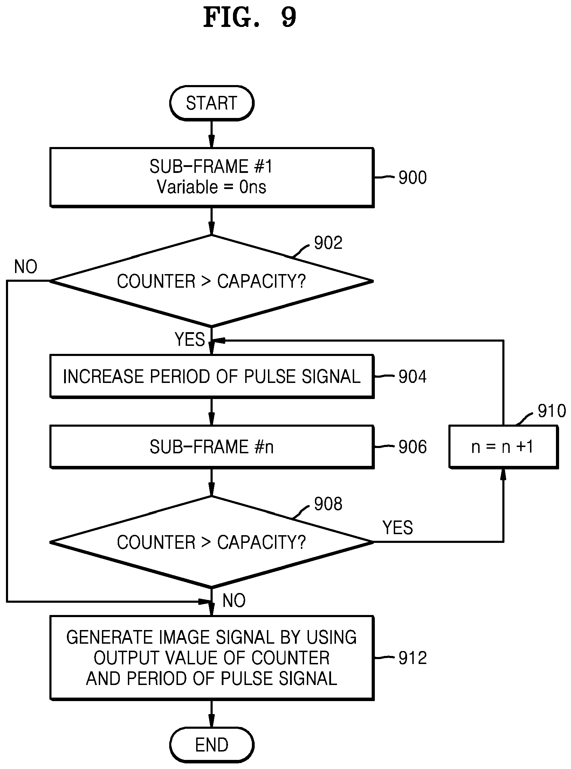

FIG. 9 is a flowchart of a method of modulating a period of a pulse signal of an image signal, according to another example embodiment.

Referring to FIG. 9, in operation 900, one frame may be divided into a plurality of sub-frames, and a variable period of a first sub-frame may be 0 ns.

**In** operation 902, it may be determined whether a counting value of the counter with respect to a first sub-frame, that is, a total sum of the number of photons counted within a period of a plurality of pulse signals in a frame period of the first sub-frame, exceeds a counter capacity. When the counting value is greater than the counter capacity in operation 902, the period of the pulse signal may be increased in operation 904.

In operation 906, it may be determined whether a counting value of a next n^{th} sub-frame is greater than the counter capacity during a period of a pulse signal, which is increased with respect to the n^{th} sub-frame.

When the counting value is greater than the counter capacity in operation 908, the period of the pulse signal may be increased with respect to a next (n+1)^{st} sub-frame, in operations 910 and 904. Here, the period of the pulse signal in operation 904 may be gradually increased with respect to each frame. Thus, the periods of the pulse signal between the sub-frames may be different from each other.

When the counting value is less than the counter capacity, in operation 908, an image signal may be generated by using an output value of the counter and the periods of the pulse signal with respect to sub-frames up to the present, in operation 912.

In an example embodiment, for photon counting in a low illuminance and a high illuminance, a period of a pulse signal may be changed, and a frame may be divided into a plurality of sub-frames, and thus, a value greater than the size of the counter may be counted with a size of the counter in a pixel being fixed.

In addition, by reducing the size of the counter, the pixel size may be reduced, and the frame rate may be improved.

The image acquisition apparatus 1000 described above may be employed in various high-performance optical apparatuses or electronic apparatuses. Examples of the electronic apparatuses may include smartphones, mobile phones, cellular phones, personal digital assistants (PDAs), laptop computers, personal computers (PCs), various portable devices, home appliances, security cameras, medical cameras, automobiles, Internet of Things (IoT) devices, and mobile or non-mobile computing devices, but are not limited thereto.

In addition to the image acquisition apparatus 1000, the electronic apparatuses may further include a processor for controlling image sensors provided therein, for example, an application processor (AP). The electronic apparatuses may control a plurality of hardware or software components by driving an operating system or an application program in the processor and may perform various data processing and operations. The processor may further include a graphics processing unit (GPU) and/or an image signal processor (ISP). When the processor includes an ISP, an image (or video) obtained using an image sensor may be stored and/or output using the processor.

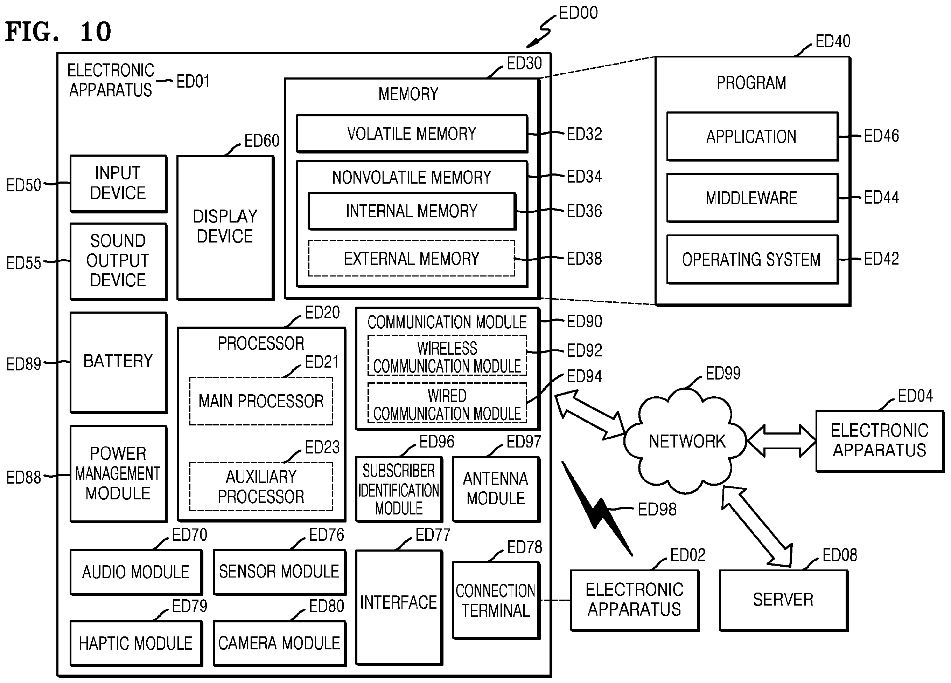

FIG. 10 is a block diagram of a schematic structure of an electronic apparatus ED01 according to an example embodiment. Referring to FIG. 10, in a network environment ED00, the electronic apparatus ED01 may communicate with another electronic apparatus ED02 through a first network ED98 (a near-field wireless communication network or the like) or may communicate with another electronic apparatus ED04 and/or a server ED08 through a second network ED99 (a far-field wireless communication network or the like). The electronic apparatus ED01 may communicate with the electronic apparatus ED04 through the server ED08. The electronic apparatus ED01 may include a processor ED20, a memory ED30, an input device ED50, a sound output device ED55, a display device ED60, an audio module ED70, a sensor module ED76, an interface ED77, a haptic module ED79, a camera module ED80, a power management module ED88, a battery ED89, a communication module ED90, a subscriber identification module ED96, and/or an antenna module ED97. Some (the display device ED60, etc.) of the components may be omitted from the electronic apparatus ED01, or other components may be added to the electronic apparatus ED01. Some of the components may be implemented in one integrated circuit. For example, the sensor module ED76 (a fingerprint sensor, an iris sensor, an illuminance sensor, etc.) may be embedded in the display device ED60 (a display or the like). In addition, when an image sensor has a spectral function, some sensor-module functions (color sensing, illuminance sensing, etc.) may be implemented in the image sensor instead of being in the sensor module ED76.

The processor ED20 may execute software (a program ED40 or the like) to control one or more other components (hardware or software components, etc.) of the electronic apparatus ED01 connected to the processor ED20, and may perform a variety of data processing or operations. As a portion of the data processing or operations, the processor ED20 may load instructions and/or data received from other components (the sensor module ED76, the communication module ED90, etc.) into a volatile memory ED32, process the instructions and/or data stored in the volatile memory ED32, and store result data in a nonvolatile memory ED34. The processor ED20 may include a main processor ED21 (a central processing unit, an AP, or the like) and an auxiliary processor ED23 (a GPU, an ISP, a sensor hub processor, a communication processor, or the like), which is operated independently or together with the main processor ED21. The auxiliary processor ED23 may consume less power than the main processor ED21 and may perform specialized functions.

The auxiliary processor ED23 may control functions and/or states related to some (the display device ED60, the sensor module ED76, the communication module ED90, etc.) of the components of the electronic apparatus ED01 on behalf of the main processor ED21 while the main processor ED21 is in an inactive (e.g., sleep) state or together with the main processor ED21 while the main processor ED21 is in an active (e.g., application execution) state. The auxiliary processor ED23 (an ISP, a communication processor, or the like) may be implemented as a portion of other functionally relevant components (the camera module ED80, the communication module ED90, etc.).

The memory ED30 may store a variety of data required by the components (the processor ED20, the sensor module ED76, etc.) of the electronic apparatus ED01. The data may include, for example, software (the program ED40, etc.) and input data and/or output data for commands related thereto. The memory ED30 may include the volatile memory ED32 and/or the nonvolatile memory ED34. The nonvolatile memory ED34 may include an internal memory ED36 fixed to the electronic apparatus ED01 and an external memory ED38 removable from the electronic apparatus ED01.

The program ED40 may be stored as software in the memory ED30, and may include an operating system ED42, middleware ED44, and/or an application ED46.

The input device ED50 may receive commands and/or data to be used for the components (the processor ED20, etc.) of the electronic apparatus ED01 from the outside (a user, etc.) of the electronic apparatus ED01. The input device ED50 may include a microphone, a mouse, a keyboard, and/or a digital pen (a stylus pen or the like).

The audio output device ED55 may output an audio signal to the outside of the electronic apparatus ED01. The audio output device ED55 may include a speaker and/or a receiver. The speaker may be used for general purposes such as multimedia playback or record playback, and the receiver may be used to receive incoming calls. The receiver may be provided as a portion of the speaker or may be implemented as a separate device.

The display device ED60 may visually provide information to the outside of the electronic apparatus ED01. The display device ED60 may include a display, a hologram device, or a projector, and a control circuit for controlling devices. The display device ED60 may include touch circuitry set to sense a touch, and/or sensor circuitry (a pressure sensor, etc.) configured to measure the intensity of force generated by the touch.

The audio module ED70 may convert sound into an electrical signal, and vice versa. The audio module ED70 may obtain sound through the input device ED50, or may output sound through the audio output device ED55 and/or speakers and/or headphones of another electronic apparatus (the electronic apparatus ED02 or the like) directly or wirelessly connected to the electronic apparatus ED01.

The sensor module ED76 may detect an operating state (power, temperature, etc.) of the electronic apparatus ED01 or an external environmental state (user status, etc.), and may generate an electrical signal and/or a data value corresponding to the detected state. The sensor module ED76 may include a gesture sensor, a gyro sensor, a barometric sensor, a magnetic sensor, an acceleration sensor, a grip sensor, a proximity sensor, a color sensor, an infrared (IR) sensor, a biological sensor, a temperature sensor, a humidity sensor, and/or an illuminance sensor.

The interface ED77 may support one or more designated protocols, which may be used to directly or wirelessly connect the electronic apparatus ED01 with other electronic apparatuses (the electronic apparatus ED02, etc.). The interface ED77 may include a high definition multimedia interface (HDMI), a universal serial bus (USB) interface, a secure digital (SD) card interface, and/or an audio interface.

A connection terminal ED78 may include a connector through which the electronic apparatus ED01 may be physically connected to other electronic apparatuses (the electronic apparatus ED02, etc.). The connection terminal ED78 may include an HDMI connector, a USB connector, an SD card connector, and/or an audio connector (a headphone connector, etc.).

The haptic module ED79 may convert an electrical signal into a mechanical stimulus (vibration, movement, etc.) or an electrical stimulus that a user may perceive through tactile sensation or kinesthesia. The haptic module ED79 may include a motor, a piezoelectric element, and/or an electric stimulation device.

The camera module ED80 may capture a still image and a moving image. The camera module ED80 may include the image acquisition apparatus 1000 described above, and may further include a lens assembly, an ISP, and/or a flash. The lens assembly included in the camera module ED80 may collect light coming from an object to be imaged.

The power management module ED88 may manage power supplied to the electronic apparatus ED01. The power management module ED88 may be implemented as a portion of a power management integrated circuit PMIC.

The battery ED89 may supply power to components of the electronic apparatus ED01. The battery ED89 may include a non-rechargeable primary battery, a rechargeable secondary battery, and/or a fuel cell.

The communication module ED90 may support establishment of a direct (wired) communication channel and/or a wireless communication channel between the electronic apparatus ED01 and other electronic apparatuses (the electronic apparatus ED02, the electronic apparatus ED04, the server ED08, etc.), and communication through the established communication channel. The communication module ED90 operates independently of the processor ED20 (an AP, etc.) and may include one or more communication processors supporting direct communication and/or wireless communication. The communication module ED90 may include a wireless communication module ED92 (a cellular communication module, a short-range wireless communication module, a global navigation satellite system (GNSS), or the like) and/or a wired communication module ED94 (a local area network (LAN) communication module, a power line communication module, or the like). A corresponding communication module from among these communication modules may communicate with other electronic apparatuses through the first network ED98 (a local area network such as Bluetooth, WiFi Direct, or infrared data association (IrDA)) or the second network ED99 (a telecommunication network such as a cellular network, the Internet, or computer networks (LAN, WAN, etc.)). These various types of communication modules may be integrated into a single component (a single chip or the like) or may be implemented as a plurality of separate components (multiple chips). The wireless communication module ED92 may identify and authenticate the electronic apparatus ED01 within a communication network such as the first network ED98 and/or the second network ED99 using subscriber information (an international mobile subscriber identifier (IMSI), etc.) stored in the subscriber identity module ED96.

The antenna module ED97 may transmit and/or receive signals and/or power to and/or from the outside (other electronic apparatuses, etc.). An antenna may include a radiator made of a conductive pattern formed on a substrate (a PCB, etc.). The antenna module ED97 may include one or more such antennas. When a plurality of antennas are included in the antenna module ED97, the communication module ED90 may select an antenna suitable for a communication method used in a communication network, such as the first network ED98 and/or the second network ED99, among the plurality of antennas. Signals and/or power may be transmitted or received between the communication module ED90 and other electronic apparatuses through the selected antenna. Other components (an RFIC, etc.) besides the antenna may be included as part of the antenna module ED97.

Some of the components may be connected to each other and exchange signals (commands, data, etc.) through a communication method between peripheral devices (a bus, general purpose input and output (GPIO), a serial peripheral interface (SPI), a mobile industry processor interface (MIPI), or the like).

Commands or data may be transmitted or received between the electronic apparatus ED01 and an external apparatus such as the electronic apparatus ED04 through the server ED08 connected to the second network ED99. The other electronic apparatuses ED02 and ED04 may be the same as or different from the electronic apparatus ED01. All or some of the operations of the electronic apparatus ED01 may be executed by one or more of the other electronic apparatuses ED02 and ED04 and the server ED08. For example, when the electronic apparatus ED01 needs to perform certain functions or services, the electronic apparatus ED01 may request one or more other electronic apparatuses to perform some or all of the functions or services instead of directly executing the functions or services. One or more other electronic apparatuses that have received the request may execute an additional function or service related to the request, and may transfer results of the execution to the electronic apparatus ED01. To this end, cloud computing, distributed computing, and/or client-server computing techniques may be used.

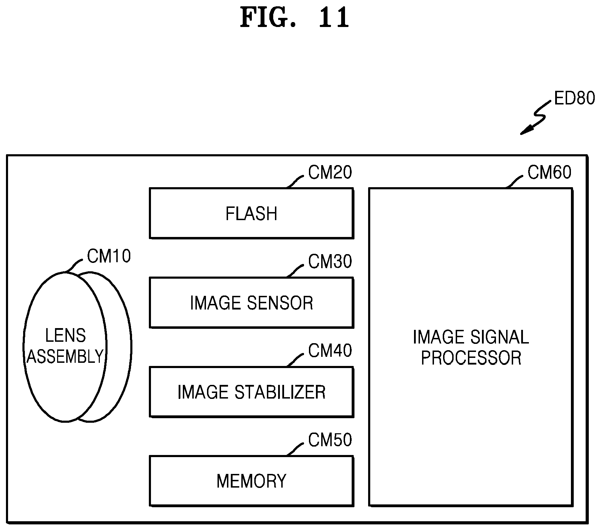

FIG. 11 is a block diagram schematic illustrating a camera module ED80 included in the electronic apparatus ED01 shown in FIG. 10. The camera module ED80 may include the image acquisition apparatus 1000 described above, or may have a structure modified therefrom. Referring to FIG. 11, the camera module ED80 may include a lens assembly CM10, a flash CM20, an image sensor CM30, an image stabilizer CM40, a memory CM50 (a buffer memory, etc.), and/or an ISP CM60.

The image sensor CM30 is an image sensor described with reference to FIGS. 1 to 3, and uses photon counting. Thus, an HDR and a high frame rate may be realized while minimizing a pixel size of the image sensor CM30. According to an example embodiment, a pixel of an image sensor includes an SPAD, generates a pulse signal based on an electric signal generated according to a photon incident on the pixel, and includes a counter that counts and outputs the number of pulse signals, and a period of the pulse signal may be modulated according to an ambient illuminance of the image sensor. Thus, in the image sensor CM30, the pixel size may be reduced, and the frame rate may be improved.

The lens assembly CM10 may collect light coming from an object to be imaged. The camera module ED80 may include a plurality of lens assemblies CM10, and in this case, the camera module ED80 may be a dual camera, a 360-degree camera, or a spherical camera. Some of the plurality of lens assemblies CM10 may have the same lens properties (field of view, focal length, autofocus, F Number, optical zoom, etc.) or different lens properties. Each of the lens assemblies CM10 may include a wide-angle lens or a telephoto lens.

The lens assembly CM10 may be configured and/or focused such that an image sensor included in the image sensor CM30 may form optical images of an object.

The flash CM20 may emit light used to enhance light emitted or reflected from an object. The flash CM20 may include one or more light emitting diodes (a red-green-blue (RGB) LED, a white LED, an infrared LED, an ultraviolet LED, etc.), and/or a xenon lamp.

The image stabilizer CM40 may move one or more lenses included in the lens assembly CM10 or the image sensor CM30 in a specific direction in response to a movement of the camera module ED80 or the electronic apparatus ED01 including the camera module ED80, or may control operating characteristics of the image sensor CM30 (adjustment of read-out timing, etc.) to compensate for negative effects caused by movement. The image stabilizer CM40 may detect a movement of the camera module ED80 or the electronic apparatus ED01 by using a gyro sensor (not shown) or an acceleration sensor (not shown) arranged inside or outside the camera module ED80. The image stabilizer CM40 may be an optical image stabilizer.

In the memory CM50, some or all of data obtained through the image sensor CM30 may be stored for the next image processing operation. For example, when a plurality of images are obtained at a high speed, the obtained original data (Bayer-patterned data, high-resolution data, or the like) may be stored in the memory CM50 and only a low-resolution image may be displayed. Then, the original data of a selected image (user selection, etc.) may be transferred to the ISP CM60. The memory CM50 may be integrated into the memory ED30 of the electronic apparatus ED01 or may be configured as a separate memory that may be independently operated.

The ISP CM60 may perform one or more image processes on an image obtained through the image sensor CM30 or image data stored in the memory CM50.

In addition, the one or more image processes may include depth map generation, three-dimensional modeling, panorama generation, feature point extraction, image synthesis, and/or image compensation (noise reduction, resolution adjustment, brightness adjustment, blurring, sharpening, softening, etc.). The ISP CM60 may control (exposure time control, read-out timing control, etc.) components (the image sensor CM30, etc.) included in the camera module CM80. An image processed by the ISP CM60 may be stored again in the memory CM50 for additional processing or may be provided to external components (the memory ED30, the display device ED60, the electronic apparatus ED02, the electronic apparatus ED04, the server ED08, etc.) of the camera module ED80. The ISP CM60 may be integrated into the processor ED20 or may be configured as a separate processor that operates independently of the processor ED20. When the ISP CM60 is provided separately from the processor ED20, an image processed by the ISP CM60 may be displayed on the display device ED60 after being further processed by the processor ED20.

The electronic apparatus ED01 may include a plurality of camera modules ED80 having different attributes or functions. In this case, one of the plurality of camera modules ED80 may be a wide-angle camera, and another of the plurality of camera modules ED80 may be a telephoto camera. Similarly, one of the plurality of camera modules ED80 may be a front camera, and another of the plurality of camera modules ED80 may be a rear camera.

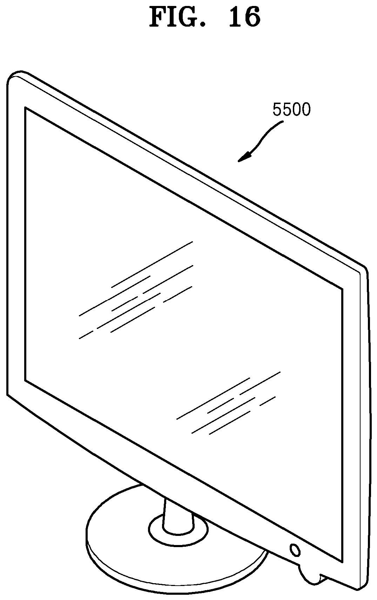

FIGS. 11 to 21 are views illustrating various examples of an electronic apparatus including the image acquisition apparatus according to example embodiments.

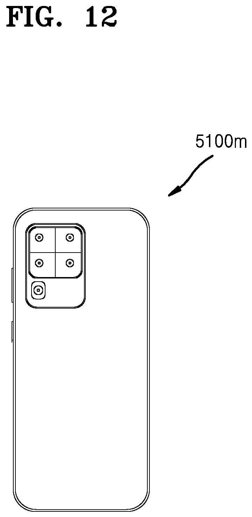

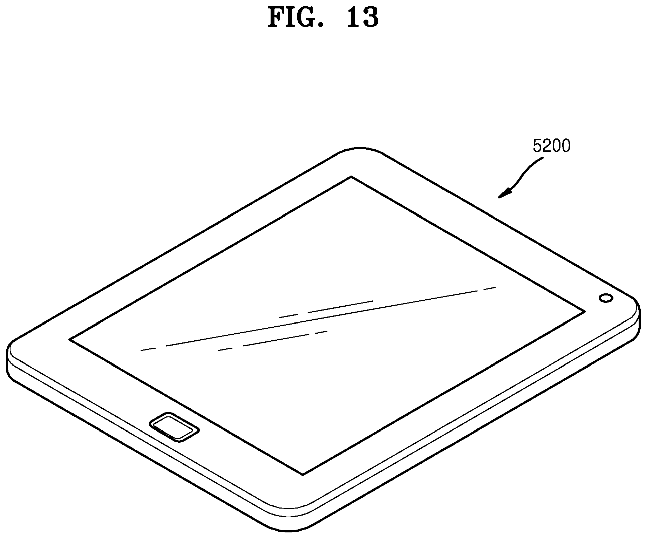

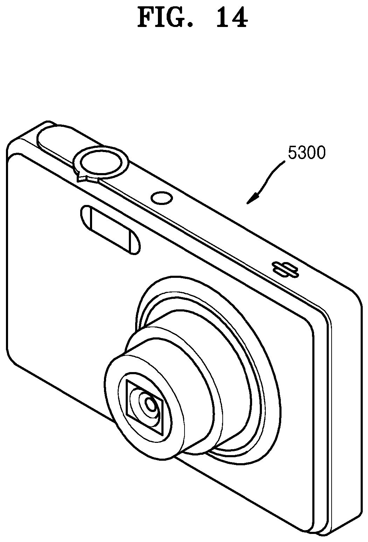

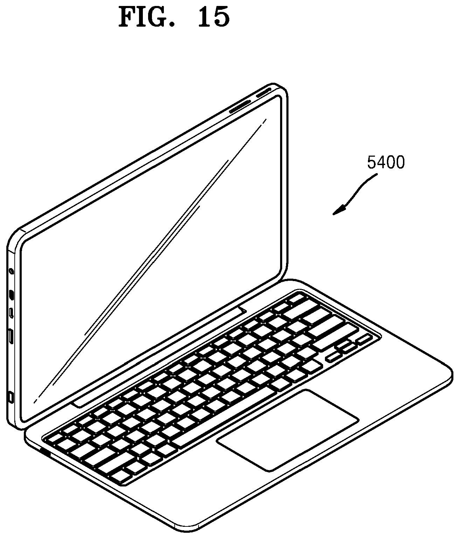

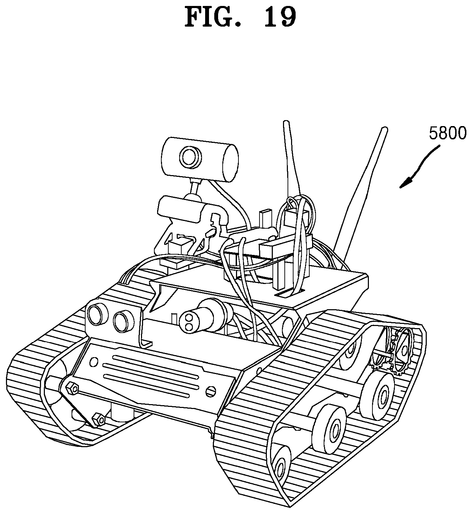

According to example embodiments, the image acquisition apparatus 1000 may be applied to a mobile phone or smartphone 5100m shown in FIG. 12, a tablet or smart tablet 5200 shown in FIG. 13, a digital camera or camcorder 5300 shown in FIG. 14, a laptop computer 5400 shown in FIG. 15, or a television or smart television 5500 shown in FIG. 19. For example, the smartphone 5100m or the smart tablet 5200 may include a plurality of high-resolution cameras each having a high-resolution image sensor mounted thereon. The high-resolution cameras may be used to extract depth information of objects in an image, adjust out of focus of an image, or automatically identify objects in an image.

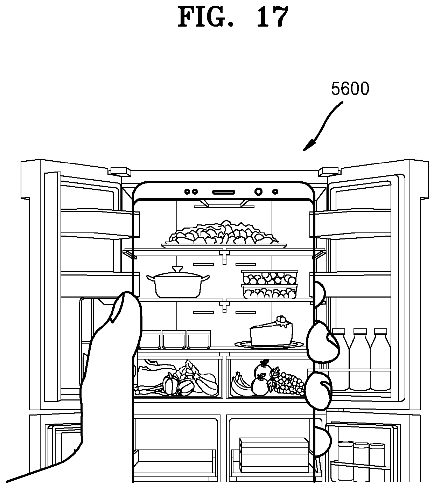

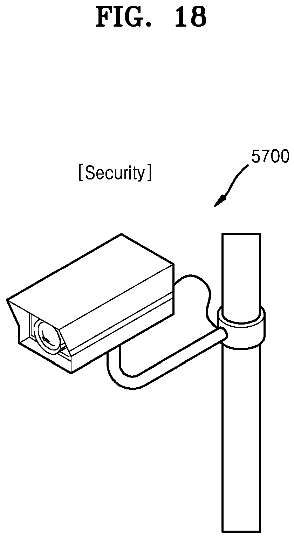

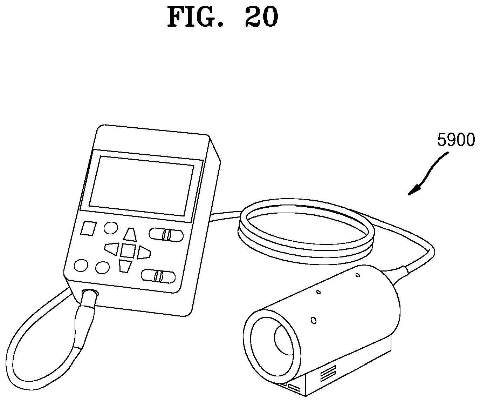

In addition, the image acquisition apparatus 1000 may be applied to a smart refrigerator 5600 shown in FIG. 17, a security camera 5700 shown in FIG. 18, a robot 5800 shown in FIG. 19, a medical camera 5900 shown in FIG. 20, and the like. For example, the smart refrigerator 5600 may automatically recognize food contained in the smart refrigerator 5600 by using the image acquisition apparatus 1000, and may inform a user of whether a specific food is contained in the smart refrigerator 5600, the type of food put into or out of the smart refrigerator 5600, and the like through a smartphone. The security camera 5700 may provide an ultra-high-resolution image and may recognize an object or a person in the ultra-high-resolution image even in a dark environment owing to high sensitivity of the security camera 5700. The robot 5800 may be sent to a disaster or industrial site that cannot be directly accessed by humans and may provide high-resolution images. The medical camera 5900 may provide a high-resolution image for diagnosis or surgery, and may have a dynamically adjustable field of view.

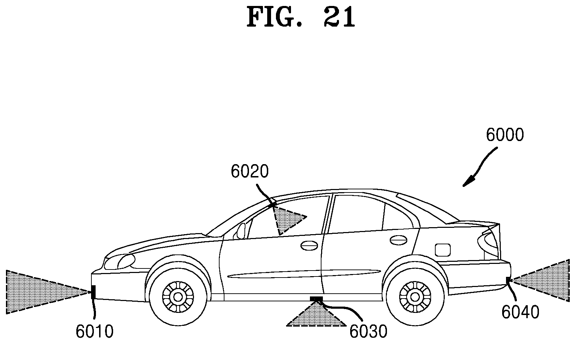

In addition, the image acquisition apparatus 1000 may be applied to a vehicle 6000 as shown in FIG. 21. The vehicle 6000 may include a plurality of vehicle cameras 6010, 6020, 6030, and 6040 arranged at various positions. Each of the vehicle cameras 6010, 6020, 6030, and 6040 may include an image acquisition apparatus according to an example embodiment. The vehicle 6000 may use the vehicle cameras 6010, 6020, 6030, and 6040 to provide a driver with a variety of information about the interior or surroundings of the vehicle 6000, and may provide information necessary for autonomous driving by automatically recognizing objects or people in images.

In an image sensor according to example embodiments, with the capacity or size of the counter in a pixel being fixed, a value greater than the size of the counter may be counted by changing a pulse period or by using a sub-frame technique.

In addition, by reducing the size of the counter, the pixel size may be reduced, and the frame rate may be improved.

The image acquisition apparatus may be employed in various electronic apparatuses.

It should be understood that example embodiments described herein should be considered in a descriptive sense only and not for purposes of limitation. Descriptions of features or aspects within each example embodiment should typically be considered as available for other similar features or aspects in other example embodiments. While one or more example embodiments have been described with reference to the figures, it will be understood by those of ordinary skill in the art that various changes in form and details may be made therein without departing from the scope as defined by the following claims.

## Claims

1. An image acquisition apparatus comprising an image sensor controller (300) and a pixel array (200) with a plurality of pixels (210), each pixel (210) comprising:
a single photon avalanche diode (211);
a pulse generator (212) configured to generate a pulse signal based on an electric signal generated when a photon is incident on the single photon avalanche diode (211); and
a counter (213) configured to count a number of pulse signals generated by the pulse generator (212) within a frame period,
wherein the image sensor controller (300) is configured to control the pulse generator (212) to increase the period of the pulse signal by a certain time when an ambient illuminance is greater than or equal to a threshold value.

2. The image acquisition apparatus according to claim 1,
wherein the image sensor controller (300) is further configured to:
generate (808) an image signal based on an output value (806) of each of the counters.

3. The image acquisition apparatus of claims 1 or 2, wherein the image sensor controller (300) is further configured to control the pulse generators (212) to increase the period of the respective pulse signal by a predetermined length, based on the output value of a respective counter (213) being greater than or equal to a threshold value.

4. The image acquisition apparatus of one of claims 1 to 3, further comprising an illuminance sensor (400) configured to detect the ambient illuminance.

5. The image acquisition apparatus of one of claims 1 to 4, wherein the image sensor controller (300) is further configured to divide the frame period into a plurality of sub-frames.

6. The image acquisition apparatus of claim 5, wherein the image sensor controller (300) is further configured to compare an output value of the respective counter (213) of a pixel (210) in a sub-frame with a capacity of the respective counter (213), and control the respective pulse generator (212) to increase the period of the respective pulse signal according to a result of the comparison.

7. The image acquisition apparatus of claims 5 or 6,
wherein the image sensor controller (300) is further configured to, based on an output value of the respective counter (213) of a pixel (210) in a first sub-frame being greater than a capacity of the respective counter (213), control the respective pulse generator (212) to increase a period of the respective pulse signal for a second sub-frame by a first time.

8. The image acquisition apparatus of claim 7, wherein the image sensor controller (300) is further configured to, based on an output value of the respective counter (213) for the second sub-frame being greater than the capacity of the respective counter (213), increase a period of the respective pulse signal for a third sub-frame by a second time that is greater than the first time, and
wherein the image sensor controller (300) is further configured to, based on an output value of the respective counter (213) for the third sub-frame being less than the capacity of the respective counter (213), generate the image signal based on the output value of the respective counter (213) for each of the first sub-frame, the second sub-frame and the third sub-frame and the period of the respective pulse signal for each of the first sub-frame, the second sub-frame and the third sub-frames.

9. The image acquisition apparatus of one of claims 5 to 8, wherein the image sensor controller (300) is further configured to:
sequentially perform a photon counting operation for each of the plurality of sub-frames.

10. The image acquisition apparatus of claim 9, wherein the period of the respective pulse signal is increased up to a sub-frame in which the output value of the respective counter (213) does not exceed the capacity of the respective counter (213), among the plurality of sub-frames.

11. The image acquisition apparatus of one of claims 1 to 10, wherein the pixel array (200), the pulse generators (212), and the counters (213) are arranged in the pixels (210), and the image sensor controller (300) is arranged outside the pixels (210).

12. An electronic apparatus comprising the image acquisition apparatus of one of claims 1 to 11.

13. A method of operating an image sensing apparatus comprising a single photon avalanche diode, SPAD (211), a pulse generator (212), a counter (213), and an controller (300), wherein the method comprises the steps of:
generating, by the pulse generator (212), a plurality of pulse signals, each corresponding to a photon incident on the SPAD (211);
counting, by the counter (213), a total number of the plurality of pulse signals generated by the pulse generator (212) within a frame period; and
increasing (904) the period of the pulse signal by a certain time when an ambient illuminance is greater than or equal to a threshold value.

## Patentansprüche

1. Bilderfassungsvorrichtung, umfassend ein Bildsensor-Steuergerät (300) und eine Pixelmatrix (200) mit einer Vielzahl von Pixeln (210), wobei jedes Pixel (210) umfasst:
eine Single Photon Avalanche Diode (211);
einen Impulserzeuger (212), ausgebildet zum Erzeugen eines Impulssignals auf der Basis eines elektrischen Signals, das erzeugt wird, wenn ein Photon auf die Single Photon Avalanche Diode (211) einfällt; und einen Zähler (213), ausgebildet zum Zählen einer Zahl von Impulssignalen, die vom Impulserzeuger (212) innerhalb eines Framezeitraums erzeugt werden,
wobei das Bildsensor-Steuergerät (300) zum Steuern des Impulserzeugers (212) so ausgebildet ist, dass es den Zeitraum des Impulssignals um eine bestimmte Zeit erhöht, wenn eine Umgebungsbeleuchtungsstärke größer gleich einem Schwellenwert ist.

2. Bilderfassungsvorrichtung nach Anspruch 1,
wobei das Bildsensor-Steuergerät (300) ferner ausgebildet ist zum:
Erzeugen (808) eines Bildsignals auf der Basis eines Ausgabewerts (806) von jedem der Zähler.

3. Bilderfassungsvorrichtung nach Anspruch 1 oder 2, wobei das Bildsensor-Steuergerät (300) ferner zum Steuern der Impulserzeuger (212) so ausgebildet ist, dass der Zeitraum des jeweiligen Impulssignals um eine vorbestimmte Länge auf der Basis des Ausgabewerts eines jeweiligen Zählers (213), der größer gleich einem Schwellenwert ist, erhöht wird.

4. Bilderfassungsvorrichtung nach einem der Ansprüche 1 bis 3, ferner umfassend einen Beleuchtungsstärkesensor (400), ausgebildet zum Erfassen der Umgebungsbeleuchtungsstärke.

5. Bilderfassungsvorrichtung nach einem der Ansprüche 1 bis 4, wobei das Bildsensor-Steuergerät (300) ferner zum Unterteilen des Framezeitraums in eine Vielzahl von Teilframes ausgebildet ist.

6. Bilderfassungsvorrichtung nach Anspruch 5, wobei das Bildsensor-Steuergerät (300) ferner zum Vergleichen von einem Ausgabewert des jeweiligen Zählers (213) eines Pixels (210) in einem Teilframe mit einer Kapazität des jeweiligen Zählers (213) und Steuern des jeweiligen Impulserzeugers (212) so, dass er den Zeitraum des jeweiligen Impulssignals entsprechend einem Ergebnis des Vergleichs erhöht, ausgebildet ist.

7. Bilderfassungsvorrichtung nach Anspruch 5 oder 6, wobei das Bildsensor-Steuergerät (300) ferner zum Steuern des jeweiligen Impulserzeugers (212) zum Erhöhen eines Zeitraums des jeweiligen Impulssignals für einen zweiten Teilframe um eine erste Zeit auf der Basis, dass ein Ausgabewert des jeweiligen Zählers (213) eines Pixels (210) in einem ersten Teilframe größer ist als eine Kapazität des jeweiligen Zählers (213), ausgebildet ist.

8. Bilderfassungsvorrichtung nach Anspruch 7, wobei das Bildsensor-Steuergerät (300) ferner zum Erhöhen eines Zeitraums des jeweiligen Impulssignals für einen dritten Teilframe um eine zweite Zeit, die größer ist als die erste Zeit, auf der Basis, dass ein Ausgabewert des jeweiligen Zählers (213) für den zweiten Teilframe größer ist als die Kapazität des jeweiligen Zählers (213), ausgebildet ist, und
wobei das Bildsensor-Steuergerät (300) ferner zum Erzeugen des Bildsignals auf das Basis des Ausgabewerts des jeweiligen Zählers (213) für jeweils den ersten Teilframe, den zweiten Teilframe und den dritten Teilframe und des Zeitraums des jeweiligen Impulssignals für jeweils den ersten Teilframe, den zweiten Teilframe und den dritten Teilframe auf der Basis, dass ein Ausgabewert des jeweiligen Zählers (213) für den dritten Teilframe kleiner ist als die Kapazität des jeweiligen Zählers (213), ausgebildet ist.

9. Bilderfassungsvorrichtung nach einem der Ansprüche 5 bis 8, wobei das Bildsensor-Steuergerät (300) ferner ausgebildet ist zum:
sequentiellen Durchführen eines Photonenzählvorgangs für jedes der Vielzahl von Teilframes.

10. Bilderfassungsvorrichtung nach Anspruch 9, wobei der Zeitraum des jeweiligen Impulssignals bis zu einem Teilframe, in dem der Ausgabewert des jeweiligen Zählers (213) nicht die Kapazität des jeweiligen Zählers (213) überschreitet, aus der Vielzahl von Teilframes erhöht wird.

11. Bilderfassungsvorrichtung nach einem der Ansprüche 1 bis 10, wobei die Pixelmatrix (200), die Impulserzeuger (212) und die Zähler (213) in den Pixeln (210) angeordnet sind und das Bildsensor-Steuergerät (300) außerhalb der Pixel (210) angeordnet ist.

12. Elektronische Vorrichtung, umfassend die Bilderfassungsvorrichtung nach einem der Ansprüche 1 bis 11.

13. Verfahren zum Betreiben einer Bildabtastvorrichtung, umfassend eine Single Photon Avalanche Diode (SPAD) (211), einen Impulserzeuger (212), einen Zähler (213) und ein Steuergerät (300), wobei das Verfahren die Schritte umfasst zum:
Erzeugen einer Vielzahl von Impulssignalen durch den Impulserzeuger (212), die jeweils einem auf die SPAD (211) einfallenden Photon entsprechen;
Zählen einer Gesamtzahl der Vielzahl von Impulssignalen, die durch den Impulserzeuger (212) innerhalb eines Framezeitraums erzeugt werden, durch den Zähler (213); und
Erhöhen (904) des Zeitraums des Impulssignals um eine bestimmte Zeit, wenn eine Umgebungsbeleuchtungsstärke größer gleich einem Schwellenwert ist.

## Revendications

1. Appareil d'acquisition d'image comprenant un dispositif de commande de capteur d'image (300) et une matrice de pixels (200) avec une pluralité de pixels (210), chaque pixel (210) comprenant :
une diode à avalanche à photon unique (211) ;
un générateur d'impulsions (212) configuré pour générer un signal d'impulsion fondé sur un signal électrique généré lorsqu'un photon est incident sur la diode à avalanche à photon unique (211) ; et
un compteur (213) configuré pour compter le nombre de signaux d'impulsion générés par le générateur d'impulsion (212) au cours d'une période de trame,
le dispositif de commande du capteur d'image (300) est configuré pour commander le générateur d'impulsions (212) afin d'augmenter la période du signal d'impulsion d'un certain temps lorsque l'éclairement ambiant est supérieur ou égal à une valeur seuil.

2. Appareil d'acquisition d'image selon la revendication 1,
dans lequel le dispositif de commande de capteur d'image (300) est en outre configuré pour :
générer (808) un signal d'image fondé sur une valeur de sortie (806) de chacun des compteurs.

3. Appareil d'acquisition d'image selon les revendications 1 ou 2, dans lequel le dispositif de commande du capteur d'image (300) est en outre configuré pour commander les générateurs d'impulsions (212) afin d'augmenter la période du signal d'impulsion respectif d'une longueur prédéterminée, sur la base de la valeur de sortie d'un compteur respectif (213) supérieure ou égale à une valeur seuil.

4. Appareil d'acquisition d'image selon l'une des revendications 1 à 3 comprend en outre un capteur d'éclairement (400) configuré pour détecter l'éclairement ambiant.

5. Appareil d'acquisition d'image selon l'une des revendications 1 à 4, dans lequel le dispositif de commande du capteur d'image (300) est en outre configuré pour diviser la période de trame en une pluralité de sous-trames.

6. Appareil d'acquisition d'image selon la revendication 5, dans lequel le dispositif de commande du capteur d'image (300) est en outre configuré pour comparer une valeur de sortie du compteur respectif (213) d'un pixel (210) dans une sous-trame avec une capacité du compteur respectif (213), et commander le générateur d'impulsions respectif (212) pour augmenter la période du signal d'impulsion respectif en fonction d'un résultat de la comparaison.

7. Appareil d'acquisition d'image selon les revendications 5 ou 6, dabs lequel le dispositif de commande du capteur d'image (300) est en outre configuré pour, sur la base d'une valeur de sortie du compteur respectif (213) d'un pixel (210) dans une première sous-image supérieure à une capacité du compteur respectif (213), commander le générateur d'impulsions respectif (212) pour augmenter une période du signal d'impulsion respectif pour une deuxième sous-image d'un premier temps.

8. Appareil d'acquisition d'image selon la revendication 7, dans lequel le dispositif de commande du capteur d'image (300) est en outre configuré pour, sur la base d'une valeur de sortie du compteur respectif (213) pour la deuxième sous-image étant supérieure à la capacité du compteur respectif (213), augmenter une période du signal d'impulsion respectif pour une troisième sous-image d'un deuxième temps qui est supérieur au premier temps, et
le dispositif de commande du capteur d'image (300) est en outre configuré pour, sur la base d'une valeur de sortie du compteur respectif (213) pour la troisième sous-image inférieure à la capacité du compteur respectif (213), générer le signal d'image sur la base de la valeur de sortie du compteur respectif (213) pour chacune de la première sous-image, de la deuxième sous-image et de la troisième sous-image et de la période du signal d'impulsion respectif pour chacune de la première sous-image, de la deuxième sous-image et de la troisième sous-image.

9. Appareil d'acquisition d'image selon l'une des revendications 5 à 8, dans lequel le dispositif de commande du capteur d'image (300) est en outre configuré pour:
effectuer séquentiellement une opération de comptage de photons pour chacune de la pluralité de sous-trames.

10. Appareil d'acquisition d'image selon la revendication 9, dans lequel la période du signal d'impulsion respectif est augmentée jusqu'à une sous-trame dans laquelle la valeur de sortie du compteur respectif (213) ne dépasse pas la capacité du compteur respectif (213), parmi la pluralité de sous-trames.

11. Appareil d'acquisition d'image selon l'une des revendications 1 à 10, dans lequel la matrice de pixels (200), les générateurs d'impulsions (212) et les compteurs (213) sont disposés dans les pixels (210), et le dispositif de commande du capteur d'image (300) est disposé à l'extérieur des pixels (210).

12. Appareil électronique comprenant l'appareil d'acquisition d'image selon l'une des revendications 1 à 11.

13. Procédé de fonctionnement d'un appareil de détection d'images comprenant une diode à avalanche à photon unique, SPAD (211), un générateur d'impulsions (212), un compteur (213) et un dispositif de commande (300), dans laquelle la méthode comprend les étapes suivantes :
générer, par le générateur d'impulsions (212), une pluralité de signaux d'impulsions, chacun correspondant à un photon incident sur le SPAD (211) ;
compter, par le compteur (213), un nombre total de la pluralité de signaux d'impulsion générés par le générateur d'impulsion (212) au cours d'une période de trame ; et
augmenter (904) la période du signal d'impulsion d'un certain temps lorsque l'éclairement ambiant est supérieur ou égal à une valeur seuil.
